**Europäisches Patentamt**

**European Patent Office**

**Office européen des brevets**

(19)

(11) Veröffentlichungsnummer: **0 075 701 B1**

(12) **EUROPÄISCHE PATENTSCHRIFT**

(45) Veröffentlichungstag der Patentschrift:
05.08.87

(21) Anmeldenummer: **82107331.9**

(22) Anmeldetag: **12.08.82**

(51) Int. Cl.⁴: **H 04 B 9/00**, G 01 R 15/07

(54) Anordnung zur Übertragung von Messwerten zu einer entfernten Stelle.

(30) Priorität: **24.09.81 DE 3138074**

(43) Veröffentlichungstag der Anmeldung:
**06.04.83 Patentblatt 83/14**

(45) Bekanntmachung des Hinweises auf die Patenterteilung:
**05.08.87 Patentblatt 87/32**

(84) Benannte Vertragsstaaten:
**FR GB**

(56) Entgegenhaltungen:
**EP - A - 0 033 237
DE - A - 2 829 949
DE - A - 2 924 581
GB - A - 2 064 112**

**ELECTRONIC DESIGN, Band 26, Nr. 9, April 1978, Seiten 78-80, Rochelle Park, USA I. MATH: "Optical-fiber links help you sidestep communications problems. Neither cable capacitance, nor water, nor power lines will stop your signal"**

(73) Patentinhaber: **Siemens Aktiengesellschaft Berlin und München, Wittelsbacherplatz 2, D-8000 München 2 (DE)**

(72) Erfinder: **Baues, Peter, Dr.Ing., Haydnstrasse 10, D-8033 Krailling (DE)**

**Beschreibung**

Die Erfindung betrifft eine Anordnung zur Übertragung von Messwerten einer Messgrösse von einer Messstelle zu einer entfernten Stelle nach dem Oberbegriff des Patentanspruchs 1.

Eine Anordnung der genannten Art ist aus der GB-A-2 064 112 bekannt. Sie ist speziell ein Feueralarmsystem also eine Anordnung zum Melden eines seltenen Ereignisses.

Aus der EP-A-10 033 238 geht ein Informationssammelsystem hervor, bei dem von einer entfernten Stelle über eine optische Leitung eine optische Signalleistung mit einer Sensoreinrichtung zugeführt wird. In dieser Sensoreinrichtung wird die optische Signalleistung moduliert und über eine optische Leitung einem entfernt angeordneten Detektor zugeführt.

Aufgabe der vorliegenden Erfindung ist es, eine in der industriellen Messtechnik einsetzbare Anordnung zur Übertragung von Messwerten einer Messgrösse von einer Messstelle zu einer entfernten Stelle zu schaffen, die es ermöglicht, in Kombination mit einer optischen Messwertübertragung die benötigte elektrische Leistung als Lichtleistung zu übertragen und die dadurch die Vorteile der optischen Signalübertragung beibehält.

Diese Aufgabe wird mit einer Anordnung der eingangs genannten Art gelöst, welche die im kennzeichnenden Teil des Patentanspruchs 1 angegebene Merkmalskombination aufweist.

Der bei dieser Lösung verwendete elektrooptische Modulator verbraucht sehr wenig Leistung und kann zuverlässig unter möglichst geringem Energieaufwand vom Sensorelement gesteuert werden. Die Bereitstellung für diese Steuerung ist zuverlässig und sicher dadurch gewährleistet, dass dem für die Leistungsversorgung der Sensoreinrichtung vorgesehenen optoelektrischen Wandler ein Spannungswandler nachgeschaltet ist, der für eine ausreichende Spannungserhöhung der von dem optoelektrischen Wandler angegebenen Spannung sorgt. Die elektronische Einrichtung und der Spannungswandler sind aus einer verlustarmen integrierten CMOS- oder I²L-Halbleiterschaltung gebildet.

Die Anordnung ist in der industriellen Messtechnik, unter anderem in der Fertigungs- und Prozesskontrolle in der Industrie, in der Militärtechnik, beispielsweise im Hinblick auf Fahrzeuge und Flugkörper, und in der Verkehrstechnik, beispielsweise bei der Steuerung von Motoren, vorteilhaft einsetzbar. Sie erfüllt das bei diesen Anwendungen bestehende Erfordernis, dass sie laufend messen kann und für eine Vielzahl von Sensoren geeignet ist, die ihre Messgrösse ständig abtasten und analoge elektrische Ausgangssignale abgeben.

Die Anordnung ist unempfindlich gegen elektromagnetische Störstrahlung und kann in Gebieten, in denen hohe elektrische Potentialdifferenzen herrschen und/oder Explosionsgefahr besteht, eingesetzt werden und gewährleistet daher die in der industriellen Messtechnik geforderte hohe Betriebssicherheit.

Vorteilhafte Ausführungsformen und Weiterbildungen der erfindungsgemässen Anordnung gehen aus den Ansprüchen 2 bis 14 hervor.

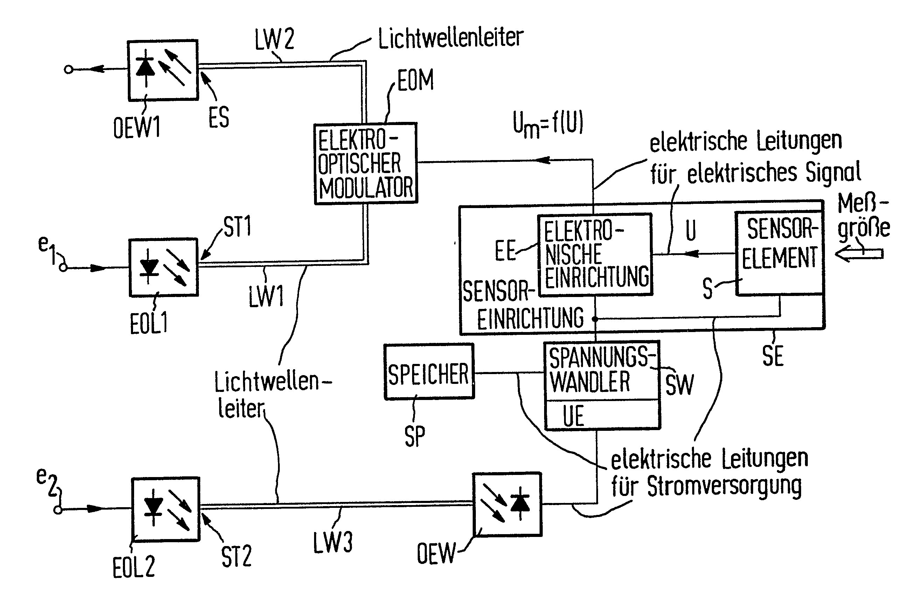

Die Erfindung wird anhand der Figur in der folgenden Beschreibung, aus der auch die wesentlichen Vorteile der Erfindung und der aus den Ansprüchen hervorgehenden Ausführungsformen und Weiterbildungen hervorgehen, näher erläutert.

Die Figur zeigt in einem Blockschaltbild den Aufbau einer erfindungsgemässen Anordnung.

In der dargestellten Anordnung erzeugt die an der Messstelle angeordnete Sensoreinrichtung SE eine von den abgetasteten Messwerten der Messgrösse abhängige elektrische Spannung als Ausgangssignal $U_m$. Diese messwertabhängige Spannung $U_m$ ist einem ebenfalls an der Messstelle und damit nahe bei der Sensoreinrichtung SE angeordneten elektrooptischen Modulator EOM als Steuersignal zugeführt. Diesem elektrooptischen Modulator EOM ist von einer von der Sensoreinrichtung SE weit entfernten Stelle ST1 über die weitere optische Leitung LW1, beispielsweise ein Lichtwellenleiter, Licht zugeführt, das in dem elektrooptischen Modulator EOM durch die messwertabhängige Spannung $U_m$ moduliert wird. Das modulierte Lichtsignal ist über die eine optische Leitung LW2, beispielsweise ein Lichtwellenleiter, einer von der Messstelle weit entfernten Entnahmestelle ES zugeführt, bei der es zur Weiterverwendung oder -verarbeitung entnommen werden kann.

Von einer ebenfalls von der Sensoreinrichtung SE bzw. der Messstelle weit entfernten Stelle ST2, die beispielsweise nahe bei der Stelle ST1 und/oder der Stelle ES angeordnet sein kann, ist über eine zweite optische Leitung LW3, beispielsweise aus einem oder mehreren Lichtwellenleitern, eine für eine Leistungsversorgung der Sensoreinrichtung SE vorgesehene Lichtleistung einem nahe bei der Sensoreinrichtung SE angeordneten optoelektrischen Wandler OEW, beispielsweise aus einem oder mehreren Fotoelementen, zuführbar. Dieser optoelektrische Wandler OEW wandelt die zugeführte Lichtleistung in eine elektrische Leistung um, die für den Betrieb eines elektrischen Teils der leistungsverbrauchenden Sensoreinrichtung SE erforderlich ist. Es sei darauf hingewiesen, dass eine Anordnung zur Leistungsübertragung über Glasfasern für sich beispielsweise aus Robertson, M.M: Power transfer via fiber optics, Proceedings of the 30th Electronic Components Conference, San Francisco, CA, USA, 28.–30. April 1980, Seiten 216–221, bekannt ist.

Allerdings ist die von einem Fotoelement abgegebene Spannung für einen direkten Betrieb von leistungsverbrauchenden Bauelementen, wie beispielsweise Halbleiterbauelementen, zu klein. Eine Spannungserhöhung kann auf dreifache Weise dadurch erreicht werden, dass die für die Leistungsversorgung vorgesehene Lichtleistung mehreren in Serie geschalteten Fotoelementen OEW zugeführt wird und/oder dass dem oder den Fotoelementen OEW ein Spannungswandler SW, beispielsweise ein Gleichspannungswandler, vorzugsweise in Verbindung mit einem Speicher SP für elektrische Energie nachgeschaltet ist.

Der Spannungswandler SW und der Speicher SP können dem elektrischen Teil der Sensoreinrichtung SE zugerechnet werden. Vorzugsweise weist die Sensoreinrichtung SE ausserdem ein Sensorelement S auf, das eine von den abgetasteten Messwerten abhängige Spannung U erzeugt, sowie eine elektronische Einrichtung EE, welche die von dem Sensorelement S erzeugte Spannung U in eine von dieser abhängigen, zur Ansteuerung des Lichtmodulators EOM geeignete Spannung $U_m = f (U)$ umwandelt. Diese Spannung $U_m$ kann eine Wechselspannung sein, deren Frequenz durch die von dem Sensorelement S erzeugte Spannung U gesteuert oder moduliert wird (Frequenzmodulation). Sie kann aber auch eine Impulsfolge sein, bei der die Impulsphase oder die Impulslänge durch die Spannung U moduliert wird. Die elektronische Einrichtung EE kann aber auch ein binär kodiertes Signal erzeugen, welches die Spannung U aus dem Sensorelement S darstellt.

Vorzugsweise ist eine nahe bei der Sensoreinrichtung SE angeordnete und an das Fotoelement OEW angekoppelte elektrisch steuerbare Unterbrechungseinrichtung UE vorgesehen, mit der die Leistungsversorgung der Sensoreinrichtung SE durch Steuersignale wahlweise unterbrechbar oder einschaltbar ist, die über die zweite optische Leitung LW3 zugeführt werden. Die Unterbrechungseinrichtung UE kann beispielsweise aus einer bistabilen Kippschaltung gebildet sein und sie kann gegebenenfalls in den Spannungswandler SW eingebaut sein.

Dadurch kann mit Hilfe einer entsprechenden Vorrichtung während einer Zeitspanne, in der die Leistungs- oder Stromversorgung für die Sensoreinrichtung SE untebrochen ist, der Speicher SP mit elektrischer Energie, die optisch übertragen wurde, aufgeladen werden.

Die Ausgangsspannung $U_m$ aus der elektronischen Einrichtung EE wird dem elektrooptischen Modulator EOM zugeführt, der den Lichtdurchgang entsprechend der Spannung $U_m$ steuert. Der elektrooptische Modulator EOM ist elektrisch gesehen eine kleine Kapazität, er kann ein bekannter Multimodemodulator (siehe Nelson, A.R.; McMahon, D.H.: Modulators for multimode single fiber communications systems. Proc. of the Technical Program, Elektro-Optical Systems Design Conf., New York, 14.–16. Sep. 1976, S. 36–39) ein Braggmodulator (siehe Auracher, F.; Keil, R.; Zeitler, K.-H.: New electrooptic Bragg deflectors with lowinsertion loss and multiple-beam capability. SFEB 10 (1981), Nr. 1, S. 44–47) oder ein Monomodewellenleitermodulator (siehe dazu die an den Schluss der Beschreibung angefügte Liste von Literaturstellen) sein.

Der Speicher SP für die elektrische Energie ist vorzugsweise ein wiederaufladbarer Speicher und kann ein Akkumulator, beispielsweise eine NC-Zelle, oder auch einfach ein Kondensator sein.

Die elektronische Einrichtung oder der elektronische Teil der Sensoreinrichtung SE bestehen vorzugsweise aus einer verlustarmen, integrierten CMOS- oder I²L-Halbleiterschaltung zur Realisierung eines der oben beschriebenen Modulationsverfahren. Solche Schaltungen sind aus der Halbleitertechnologie bekannt und können ohne Schwierigkeiten aufgebaut werden. Spannungswandler sind beispielsweise in Robertson, M.M.: Power transfer via fiber optics. Proceedings of the 30th Electronic Components Conference, San Francisco, CA, USA, 28.–30. April 1980, S. 216–21, und Brosio, A.; Perino, M.; Solina, P.: A low consumption, light powered telephone on optical fibre, Sixth Europian Conference on Optical Communication, York U.K., 16.–19. Sept. 1980, S. 242–245, erwähnt.

Zur Einkoppelung von Lichtleistung an den entfernten Stellen ST1 und ST2 ist vorzugsweise jeweils eine Einrichtung EOL1 bzw. EOL2 zur elektrooptischen Leistungsumwandlung vorgesehen, deren abgegebene Lichtleistung als Signallichtleistung in die weitere optische Leitung LW1 bzw. als Lichtleistung für die Leistungsversorgung in die zweite optische Leitung LW3 eingekoppelt wird. Jede dieser Einrichtungen EOL1 bzw. EOL2 weist einen Eingang e1 bzw. e2 auf, über die jeweils die in Lichtleistung umzuwandelnde elektrische Leistung zugeführt wird.

Das Licht für die Signallichtleistung und für die Lichtleistung für die elektrische Versorgung kann als Gleichlicht oder moduliert, beispielsweise in Form einer regelmässigen Impulsfolge in die entsprechenden optischen Leitungen LW1 bzw. LW3 eingekoppelt werden. Bei impulsförmiger Einspeisung lässt sich zum einen die Streckenlänge zwischen der Messstelle bzw. der Sensoreinrichtung und den entfernten Stellen ST1 und ST2, beispielsweise in einer Zentrale, infolge jetzt möglicher, hoher Impulsleistungsspitzen verlängern. Zum anderen entstehen durch den vom Fotoelement abgegebenen Wechselstrom Vorteile für die halbleitertechnologische Realisierung des Spannungswandlers SW.

Die Einrichtungen EOL1 und EOL2 zur elektrooptischen Leistungsumwandlung können Lichtsender der verschiedensten Art sein: Laser jeder Art, darunter Halbleiterlaser, Festkörperlaser, Gaslaser sowie Lumineszenzdioden. Zur Herstellung von Halbleiterlasern (siehe Panish, M.B.: Heterojunction Injection Lasers. IEEE MTT-23 (1975), S. 20–30) und Lumineszenzdioden (siehe Lebailly, J.: Situation des diodes électroluminescentes pour liaisons par fibres optiques. Acta Electronica 22 (1979), Nr. 4, S. 301–310) werden je nach Lichtwellenlänge verschiedene Materialien benutzt: beispielsweise ternäre Halbleiter wie (GaAl)As oder (InGa)As bzw. quarternäre Halbleiter wie (GaIn) (AsP) (siehe Heinlein, W.; Witte, K.H.: Digitale Übertragung über optische Wellenleiter im Wellenlängenbereich oberhalb 1 µm. Frequenz 32 (1978), No. 3, S. 79–84). Für Lumineszenzdioden kommen auch binäre Halbleiter wie GaP in Frage. Gaslaser sind z.B. He-Ne-Laser. Für die zur Leistungsübertragung dienende Einrichtung EOL2 sind auch Xenon-Bogenlampen verwendbar.

An der Entnahmestelle ES, die beispielsweise ebenfalls in der Zentrale liegen kann, ist zweckmässigerweise eine Fotodiode oder Avalanchefotodiode OEW1 mit vorzugsweise nachgeschalteter Verstärkung vorgesehen, welche das zur Entnahmestelle ES geführte modulierte Signallicht wieder in elektrische Signale umwandelt. Die Fotodioden bestehen meist aus Silizium (siehe Melchior H.: Sensitive high speed Photodetectors for the demodulation of visible and near infrared light. J. Luminescence 7 (1973), S. 390–414), aber auch Germaniumfotodioden (siehe Ando, H.; Kanbe, H.; Kimura, T.; Yamaoka, T.; Kaneda T.: Caracteristics of Germanium Avalanche Photodiodes in the Wavelength Region of 1–1.6 µm IEEE QE-14 (1978), No. 11, S. 804–909) für grössere Wellenlängen des Lichts kommen in Frage. Wie die Laser- und Lumineszenzdioden können die Fotodioden auch aus ternären oder quarternären Halbleitern hergestellt werden.

Das Fotoelement ist eine spezielle Fotodiode zur Umwandlung optischer in elektrische Energie, es wird je nach der Wellenlänge des empfangenen Lichts aus den gleichen Materialien wie die Fotodiode hergestellt.

Die Lichtwellenleiter können Stufenprofil-, Gradienten- oder Monomodewellenleiter sein. Dickkernfasern mit besonders grossem Kernquerschnitt kommen gleichfalls in Frage.

Die Leistungs- oder Stromversorgung für das Sensorelement ist fakultativ. Es gibt Sensorelemente, die der Messgrösse soviel Leistung entnehmen, dass damit eine Spannung erzeugt werden kann, die zur Ansteuerung der elektronischen Einrichtung EE ausreicht. Derartige Sensoren sind z. B. piezoelektrische Wandler, Thermoelemente, Halleffektwandler usw.

Andere Sensorelemente benötigen zur Erzeugung der Spannung U eine Stromversorgung. Zu diesen gehören z. B. Dehnungsmessstreifen, beispielsweise in Form von Brückenschaltungen, kapazitive Druckaufnehmer usw.

Die leistungsverbrauchende Sensoreinrichtung SE, gegebenenfalls mit der elektronischen Einrichtung EE, und die mit diesen elektrisch gekoppelten Teile, also der optoelektrische Wandler OEW, der Spannungswandler SW, gegebenenfalls die Unterbrechungseinrichtung UE, gegebenenfalls der Speicher SP für elektrische Energie und der elektrooptische Modulator EOM werden zweckmässigerweise zu einer Baueinheit zusammengefasst. Insbesondere ist es zweckmässig, die genannten Teile vollständig so in elektrisch isolierendes Material, beispielsweise PVC, einzubetten oder -giessen, dass nur noch das die Messwerte abtastende Sensorelement von aussen zugänglich ist. Diese Bauweise empfiehlt sich für den Einsatz in Gebieten, in denen Explosionsgefahr und/oder hohe elektrische Potentialdifferenzen herrschen. Es lässt sich mit ihr auf relativ billige Weise ein sehr hoher Sicherheitsgrad erreichen.

Generell ist eine vorgeschlagene Anordnung zur Potentialtrennung hervorragend geeignet.

Der durch optisch zugeführte Energie aufladbare Speicher SP ermöglicht die Überbrückung sehr grosser Entfernungen.

Die oben verwendeten Begriffe «entfernt» und «nahe» sind qualitativ zu verstehen. Eine von der Sensoreinrichtung SE entfernte Stelle ist von dieser weiter entfernt als eine nahe bei der Sensoreinrichtung SE befindliche Stelle. In der Praxis wird eine von der Sensoreinrichtung SE entfernte oder weit entfernte Stelle häufig in der Grössenordnung von 1 m und mehr von der Sensoreinrichtung entfernt sein, während ein nahe bei der Sensoreinrichtung liegendes Teil in der Grössenordnung von 1 cm und darunter, im Fall einer integrierten Schaltung sogar weit darunter, vom Sensorelement entfernt sein wird.

**Patentansprüche**

1. Anordnung zur Übertragung von Messwerten einer Messgrösse von einer Messstelle zu einer entfernten Stelle (ES), wobei eine an der Messstelle angeordnete, die Messgrösse abtastende und die abgetasteten Messwerte in Form eines messwertabhängigen Ausgangssignal ($U_m$) ausgebende Sensoreinrichtung (SE) vorgesehen ist, deren elektrisches Ausgangssignal ($U_m$) einem nahe bei der Sensoreinrichtung (SE) angeordneten elektrooptischen Wandler (EOM) zuführbar ist, von dem die optische Signalleistung über eine optische Leitung (LW2) der entfernten Stelle (ES) zuführbar ist, wobei von einer von der Sensoreinrichtung (SE) entfernten Stelle (ST2) über eine zweite optische Leitung (LW3) eine für eine Leistungsversorgung der Sensoreinrichtung (SE) vorgesehene optische Leistung wenigstens einem nahe bei der Sensoreinrichtung (SE) angeordneten und mit dieser sowie mit einem Speicher (SP) für elektrische Energie in Verbindung stehenden optoelektronischen Wandler (OEW) zuführbar ist, der die zugeführte optische Leistung in eine elektrische Leistung umwandelt, die für den Betrieb einer elektronischen Einrichtung (EE) der Sensoreinrichtung (SE) erforderlich ist, welche elektronische Einrichtung (EE) mit einem Sensorelement (S) dieser Sensoreinrichtung (SE) verbunden ist, das ein von den abgetasteten Messwerten abhängiges elektrisches Signal (U) erzeugt, welches von der elektronischen Einrichtung (EE) in ein von diesem Signal (U) abhängiges, zur Ansteuerung des elektrooptischen Wandlers (EOM) geeignetes elektrisches Signal ($U_m$) umgewandelt wird, dadurch gekennzeichnet, dass der elektrooptische Wandler (EOM) aus einem elektrooptischen Modulator besteht, dem von einer von der Sensoreinrichtung (SE) entfernten anderen Stelle (ST1) über eine weitere optische Leitung (LW1) eine optische Signalleistung zuführbar ist, der in dem Modulator (EOM) das elektrische Ausgangssignal ($U_m$) aufprägbar ist und von dem die entsprechend modulierte optische Signalleistung über die eine optische Leitung (LW2) der entfernten Stelle (ES) zuführbar ist, dass dem optoelektronischen Wandler (OEW) ein Spannungswandler (SW) nachgeschaltet ist, der mit dem Speicher (SP) und der Sensoreinrichtung (SE) verbunden ist, und dass zumindest die elektronische Einrichtung (EE) und der Spannungswandler (SW) aus einer verlustarmen integrierten CMOS- oder $I^2$L-Halbleiterschaltung gebildet sind.

2. Anordnung nach Anspruch 1, dadurch gekennzeichnet, dass mehrere in Serie geschaltete optoelektronische Wandler (OEW) vorgesehen sind, denen der Spannungswandler (SW) nachgeschaltet ist.

3. Anordnung nach Anspruch 1 oder 2, dadurch gekennzeichnet, dass der Speicher (SP) für elektrische Energie in einer CMOS- oder $I^2$L-Halbleiterschaltung realisiert ist.

4. Anordnung nach einem der vorhergehenden Ansprüche, dadurch gekennzeichnet, dass das von der elektronischen Einrichtung (EE) erzeugte elektrische Signal ($U_m$) eine Wechselspannung, deren Frequenz durch das von dem Sensorelement (S) erzeugte elektrische Signal (U) moduliert wird, oder eine Impulsfolge, bei der die Impulsphase und/oder die Impulslänge durch das elektrische Signal (U) aus dem Sensorelement (S) moduliert wird, oder ein das elektrische Signal (U) aus dem Sensorelement (S) darstellendes binär kodiertes Signal ist.

5. Anordnung nach einem der vorhergehenden Ansprüche, dadurch gekennzeichnet, dass eine nahe bei der Sensoreinrichtung (SE) angeordnete, an den optoelektronischen Wandler (OEW) angekoppelte elektrisch steuerbare Unterbrechungseinrichtung (UE) vorgesehen ist, mit der die Leistungsversorgung der Sensoreinrichtung (SE) durch über die weitere optische Leitung (LW3) zugeführte Steuersignale wahlweise unterbrechbar oder einschaltbar ist.

6. Anordnung nach Anspruch 5, dadurch gekennzeichnet, dass die Unterbrechungseinrichtung (UE) aus einer bistabilen Kippschaltung gebildet ist.

7. Anordnung nach Anspruch 5 oder 6, dadurch gekennzeichnet, dass eine Ladevorrichtung vorgesehen ist, welche während einer Zeitspanne, in der die Leistungsversorgung für die Sensoreinrichtung (SE) unterbrochen ist, den Speicher (SP) für die elektrische Energie aus optisch übertragener Energie auflädt.

8. Anordnung nach einem der vorhergehenden Ansprüche, dadurch gekennzeichnet, dass eine Einrichtung (EOL2) zur elektrooptischen Leistungsumwandlung vorgesehen ist, deren optische Ausgangsleistung als optische Leistung für die Leistungsversorgung in die zweite optische Übertragungsleitung (LW3) einkoppelbar ist und/oder dass eine Einrichtung (EOL1) zur elektrooptischen Leistungsumwandlung vorgesehen ist, deren optische Ausgangsleistung als optische Signalleistung in die erste optische Übertragungsleitung (LW1) einkoppelbar ist und/oder dass ein weiterer optoelektronischer Wandler (OEW1) vorgesehen ist, in den die zur Entnahmestelle (ES) zugeführte modulierte optische Signalleistung einkoppelbar ist.

9. Anordnung nach Anspruch 8, dadurch gekennzeichnet, dass eine Einrichtung (EOL1, EOL2) zur elektrooptischen Leistungsumwandlung einen Lichtsender in Form eines Lasers oder einer Lumineszenzdiode und die Einrichtung (EOL2), deren optische Ausgangsleistung als optische Leistung in die zweite optische Übertragungsleitung (LW3) einkoppelbar ist, als Lichtsender auch eine Xenon-Bogenlampe aufweist.

10. Anordnung nach Anspruch 8 oder 9, dadurch gekennzeichnet, dass eine Einrichtung (EOL1, EOL2) zur elektrooptischen Leistungsumwandlung Gleichlicht oder eine regelmässige Impulsfolge als optische Ausgangsleistung abgibt.

11. Anordnung nach einem der Ansprüche 8 bis 10, dadurch gekennzeichnet, dass der weitere optoelektronische Wandler (OEW1) eine Fotodiode oder Avalanche-Fotodiode mit nachgeschalteter Verstärkung aufweist.

12. Anordnung nach einem der vorhergehenden Ansprüche, dadurch gekennzeichnet, dass zumindest eine der optischen Leitungen (LW1, LW2, LW3) aus einer Dickkernfaser, im Falle der zweiten optischen Leitung (LW3) auch aus mehreren Dickkernfasern besteht.

13. Anordnung nach einem der vorhergehenden Ansprüche, dadurch gekennzeichnet, dass der elektrooptische Modulator (EOM) aus einem Monomodewellenleitermodulator oder einem Multimodemodulator besteht.

14. Anordnung nach Anspruch 13, dadurch gekennzeichnet, dass der Multimodemodulator ein Bragg-Modulator ist.

**Claims**

1. An arrangement for transmitting measured values of a measured variable from a measuring station to a remote station (ES), where a sensor device (SE) is provided which is arranged at the measuring station, samples the measured variable and emits the sampled measured values in the form of a measured-value-dependent output signal ($U_m$) and whose electrical output signal ($U_m$) can be supplied to an electro-optical transducer (EOM) which is arranged close to the sensor device (SE) and from which the optical signal power can be supplied via an optical line (LW2) to the remote station (ES), where, from a station (ST2) which is remote from the sensor device (SE), via a second optical line (LW3), an optical power provided for the power supply of the sensor device (SE) can be supplied to at least one opto-electronic transducer (OEW) which is arranged close to the sensor device (SE) and is connected to said sensor device and to a store (SP) for electrical energy, and which converts the optical power into electrical power required for the operation of an electronic device (EE) of the sensor device (SE), where said electronic device (EE) is connected to a sensor element (S) of this sensor device (SE) which produces an electrical signal (U) which is dependent upon the sampled measured values and which is converted by the electronic device (EE) into an electrical signal ($U_m$) which is dependent upon the signal (U) and which is suitable to drive the electro-optical transducer (EOM), charac-

terised in that the electro-optical transducer (EOM) comprises an electro-optical modulator which can be supplied from another station (ST1), remote from the sensor device (SE), via a further optical line (LW1) with an optical signal power on to which the electrical output signal ($U_m$) can be impressed in the modulator (EOM), and from which modulator the appropriately modulated optical signal power can be supplied via the first optical line (LW2) to the remote station (ES), that the opto-electronic transducer (OEW) is connected at its output to a voltage transformer (SW) which is connected to the store (SP) and to the sensor device (SE), and that at least the electronic device (EE) and voltage transformer (SW) comprises a low-loss, integrated CMOS- or $I^2L$-semiconductor circuit.

2. An arrangement as claimed in claim 1, characterised in that a plurality of series-connected opto-electronic transducers (OEW) are provided which are connected at their output end to the voltage transformer (SW).

3. An arrangement as claimed in claim 1 or 2, characterised in that the store (SP) for electrical energy is constructed in a CMOS- or $I^2L$-semiconductor circuit.

4. An arrangement as claimed in one of the preceding claims, characterised in that the electrical signal ($U_m$) which is generated by the electronic device (EE) is an ac voltage, the frequency of which is modulated by the electrical signal (U) generated by the sensor element (S), or a pulse sequence in which the pulse phase and/or the pulse length is modulated by the electrical signal (U) from the sensor element (S), or is a binary-coded signal which represents the electrical signal (U) from the sensor element (S).

5. An arrangement as claimed in one of the preceding claims, characterised in that an electrically controllable interruption device (UE) is provided which is arranged close to the sensor device (SE), is coupled to the opto-electronic transducer (OEW) and serves to permit the power supply of the sensor device (SE) to be selectively interrupted or connected by means of control signals supplied via the further optical line (LW3).

6. An arrangement as claimed in claim 5, characterised in that the interruption device (UE) comprises a bistable flip-flop.

7. An arrangement as claimed in claim 5 or 6, characterised in that a charging device is provided which, during a period of time in which the power supply for the sensor device (SE) is interrupted, charges the store (SP) for electrical energy with optically transmitted energy.

8. An arrangement as claimed in one of the preceding claims, characterised in that a device (EOL2) for electro-optical power conversion is provided, the optical output power of which can be input-coupled into the second optical transmission line (LW3) as optical power for the power supply, and/or that a device (EOL1) for electro-optical power conversion is provided, the optical output power of which can be input-coupled into the first optical transmission line (LW1) as optical signal power, and/or that a further opto-electronic transducer (OEW1) is provided into which the modulated, optical signal power supplied to the receiving station (ES) can be input-coupled.

9. An arrangement as claimed in claim 8, characterised in that a device (EOL1, EOL2) for electro-optical power conversion includes a light transmitter in the form of a laser or a light-emitting diode and the device (EOL2), whose optical output power can be input-coupled into the second optical transmission line (LW3) as optical power, also includes a xenon arc lamp as light transmitter.

10. An arrangement as claimed in claim 8 or 9, characterised in that a device (EOL1, EOL2) for electro-optical power conversion emits constant light or a regular pulse sequence as optical output power.

11. An arrangement as claimed in one of the claims 8 to 10, characterised in that the further opto-electronic transducer (OEW1) comprises a photo-diode or avalanche-photo-diode connected at its output end to an amplifier.

12. An arrangement as claimed in one of the preceding claims, characterised in that at least one of the optical lines (LW1, LW2, LW3) comprises a thick-core fibre, whilst the second optical line (LW3) also comprises a plurality of thick-core fibres.

13. An arrangement as claimed in one of the preceding claims, characterised in that the electro-optical modulator (EOM) comprises a monomode waveguide modulator or a multimode modulator.

14. An arrangement as claimed in claim 13, characterised in that the multimode modulator is a Bragg modulator.

**Revendications**

1. Dispositif pour transmettre des valeurs de mesure d'une grandeur de mesure depuis un emplacement de mesure jusqu'à un emplacement éloigné (ES), et dans lequel il est prévu un dispositif de détection (SE) qui est disposé au niveau de l'emplacement de mesure, explore les grandeurs de mesure et délivre les valeurs de mesure explorées sous la forme d'un signal de sortie ($U_m$) dépendant de la valeur de mesure et dont le signal de sortie électrique ($U_m$) peut être envoyé à un transducteur électro-optique (EOM) installé dans le dispositif de détection (SE) et à partir duquel la puissance optique du signal peut être envoyée par l'intermédiaire d'un conducteur optique (LW2) à l'emplacement éloigné (ES), et dans lequel une puissance optique prévue pour l'alimentation en puissance du dispositif de détection (SE) peut être envoyée à partir d'un emplacement (ST2) éloigné du dispositif de détection (SE), par l'intermédiaire d'un second conducteur optique (LW3), à un transducteur opto-électronique (OEW) qui est disposé à proximité du dispositif de détection (SE), est relié à ce dernier ainsi qu'a un accumulateur (SP) pour l'énergie électrique et convertit la puissance optique envoyée en une énergie électrique qui est nécessaire pour le fonctionnement d'un dispositif électronique (EE) du dispositif de détection (SE), lequel dispositif électronique (EE) est relié à un élément formant capteur (S) de ce dispositif de détection (SE), qui produit un signal électrique (U) qui dépend des valeurs de mesure explorées et est converti par le dispositif électronique (EE) en un signal électrique (U$_m$), qui dépend de ce signal (U) et convient pour réaliser la commande du transducteur électro-optique (EOM), caractérisé par le fait que le transducteur électro-optique (EOM) est constitué par un modulateur électro-optique, auquel peut être envoyé, par l'intermédiaire d'un conducteur optique supplémentaire (LW1), et ce à partir d'un autre emplacement (ST1) éloigné du dispositif de détection (SE), une énergie optique du signal à laquelle peut être superposé, dans le modulateur (OM), le signal de sortie électrique (U$_m$), et à partir duquel l'énergie du signal optique modulée de façon correspondante peut être envoyée par l'intermédiaire d'un conducteur optique (LW2) à l'emplacement éloigné (ES), qu'en aval du transducteur optoélectronique (OEW) se trouve branché un convertisseur de tension (SW), qui est relié à la mémoire (SP) et au dispositif de détection (SE), et qu'au moins le dispositif électronique (SE) et le convertisseur de tension (SW) sont constitués par un circuit à semi-conducteurs CMOS ou I$^2$L intégré et présentant de faibles pertes.

2. Dispositif suivant la revendication 1, caractérisé par le fait qu'il est prévu plusieurs convertisseurs opto-électroniques (OEW) branchés en série, en aval desquels le convertisseur de tension (SW) est branché.

3. Dispositif suivant la revendication 1 ou 2, caractérisé par le fait que l'accumulateur (ST) pour l'énergie électrique est réalisé dans un circuit à semiconducteurs CMOS ou I$^2$L.

4. Dispositif suivant l'une des revendications précédentes, caractérisé par le fait que le signal électrique (U$_m$) produit par le dispositif électronique (EE) est une tension alternative, dont la fréquence est modulée par le signal électrique (U) produit par l'élément formant capteur (S), ou une suite d'impulsions, pour laquelle la phase des impulsions et/ou la durée des impulsions est modulée par le signal électrique (U) délivré par l'élément formant capteur (S), ou bien un signal codé en binaire représentant le signal électrique (U) délivré par l'élément formant capteur (S).

5. Dispositif suivant l'une des revendications précédentes, caractérisé par le fait qu'il est prévu un dispositif d'interruption (UE) pouvant être commandé par voie électrique, disposé à proximité du dispositif de détection (SE) et couplé au convertisseur opto-électronique (OEW) et à l'aide duquel l'alimentation en énergie du dispositif de détection (SE) peut être, au choix, interrompue ou branchée par des signaux de commande envoyés par l'intermédiaire de la ligne optique supplémentaire (LW3).

6. Dispositif suivant la revendication 5, caractérisé par le fait que le dispositif d'interruption (UE) est formé par un circuit à bascule bistable.

7. Dispositif suivant la revendication 5 ou 6, caractérisé par le fait qu'il est prévu un dispositif de chargement qui charge l'accumulateur (SP) pour la charge électrique, avec une énergie transmise par voie optique, pendant un intervalle de temps pendant lequel l'alimentation en énergie du dispositif de détection (SE) est interrompue.

8. Dispositif suivant l'une des revendications précédentes, caractérisé par le fait qu'il est prévu un dispositif (EOL2) servant à réaliser la conversion électro-optique de l'énergie et dont l'énergie optique de sortie peut être injectée par couplage, en tant qu'énergie optique pour l'alimentation en énergie, dont le second conducteur optique de transmission (LW3) et/ou qu'il est prévu un dispositif (EOL1) servant à réaliser la conversion électro-optique de l'énergie et dont l'énergie optique de sortie peut être injectée par couplage en tant que puissance optique du signal dans la première ligne optique de transmission (LW1) et/ou qu'il est prévu un convertisseur opto-électronique supplémentaire (OEW1), dans lequel peut être injectée par couplage l'énergie du signal optique modulée, envoyée à l'emplacement de prélèvement (ES).

9. Dispositif suivant la revendication 8, caractérisé par le fait qu'un dispositif (EOL1, EOL2) servant à réaliser la conversion électro-optique de l'énergie comporte un émetteur de lumière réalisé sous la forme d'un laser ou d'une diode à luminescence et que le dispositif (EOL2), dont l'énergie optique de sortie peut être injectée par couplage en tant qu'énergie optique dans le second conducteur optique de transmission (LW3), comporte en tant qu'émetteur de lumière également une lampe à arc au xénon.

10. Dispositif suivant la revendication 8 ou 9, caractérisé par le fait qu'un dispositif (EOL1, EOL2) servant à réaliser la conversion électro-optique de l'énergie, délivre une lumière continue ou une suite régulière d'impulsions en tant qu'ènergie optique de sortie.

11. Dispositif suivant l'une des revendications 8 à 10, caractérisé par le fait que le convertisseur opto-électronique supplémentaire (EOW1) comporte une photodiode ou une photodiode à avalanche, en aval de laquelle est branché un amplificateur.

12. Dispositif suivant l'une des revendications précédentes, caractérisé par le fait qu'au moins l'un des conducteurs optiques (LW1, LW2, LW3) est constitué par une fibre à cœur épais et que dans le cas du second conducteur optique (LW3), il est également prévu plusieurs fibres à cœur épais.

13. Dispositif suivant l'une des revendications précédentes, caractérisé par le fait que le modulateur électro-optique (EOM) est constitué par un modulateur de guide d'ondes monomode ou un modulateur multimodes.

14. Dispositif suivant la revendication 13, caractérisé par le fait que le modulateur multimodes est un modulateur de Bragg.